# EUROPÄISCHE PATENTSCHRIFT

(11) **EP 2 041 991 B1**
(45) Veröffentlichungstag und Bekanntmachung des Hinweises auf die Patenterteilung: **15.09.2010**
(21) Anmeldenummer: 07785967.6
(22) Anmeldetag: 06.07.2007
(51) Int. Cl.: H04W 24/06

(54) **VERFAHREN UND SYSTEM ZUR ERMITTLUNG DER ABHÄNGIGKEIT ZWISCHEN GERÄTEPARAMETERN EINES MOBILFUNKGERÄTS UND SIGNALGRÖSSEN**
METHOD AND SYSTEM FOR DETERMINING THE RELATIONSHIP BETWEEN DEVICE PARAMETERS OF A CELLULAR DEVICE AND SIGNAL PARAMETERS
PROCÉDÉ ET SYSTÈME DESTINÉS À DÉTERMINER L'INTERDÉPENDANCE ENTRE DES PARAMÈTRES D'UN APPAREIL DE TÉLÉPHONIE MOBILE ET DES GRANDEURS DE SIGNAL

(30) Priorität: 17.07.2006 DE 102006032961
(43) Veröffentlichungstag der Anmeldung: 01.04.2009
(73) Patentinhaber: Rohde & Schwarz GmbH & Co. KG, 81671 München (DE)
(72) Erfinder: LORENZEN, Rolf, 82008 Unterhaching (DE)
(74) Vertreter: Körfer, Thomas
(86) Internationale Anmeldenummer: PCT/EP2007/006101
(87) Internationale Veröffentlichungsnummer: WO 2008/009373

(56) Entgegenhaltungen:
- WO-A-00/40049
- WO-A-2006/034843
- FR-A- 2 861 945
- US-A1- 2002 077 093

## Beschreibung

Die Erfindung betrifft ein Verfahren und ein System zur Ermittlung der Abhängigkeit zwischen Geräteparametern eines Mobilfunkgeräts und Signalgröße eines vom Mobilfunkgerät gesendeten und/oder empfangenen Signals.

Ein wichtiger Fertigungsschritt in der Produktion von Mobilfunkgeräten ist die Prüfung der Güte von unterschiedlichen Signalgrößen - beispielsweise des Error-Modulation-Vectors (EMV) oder des Code-Domain-Parameters (CDP) - des vom zu prüfenden Mobilfunkgeräts gesendeten oder empfangenen Signals in Abhängigkeit bestimmter Geräteparameterwerte im Empfangs- und/oder Sendekanal des Mobilfunkgeräts - beispielsweise der Offsetspannung des Empfangs- oder Sendeverstärkers -, um fehlerhafte Mobilfunkgeräte am Ende der Produktion zu identifizieren. Die gemessenen Signalgrößen werden hierzu mit den den korrekten Toleranzbereich festlegenden Schwellwerten verglichen.

WO 2006/034843 A (ROHDE & SCHWARZ [DE]; PLAUMANN RALF [DE]; TIROCH DIETER [DE]) 6. April 2006 offenbart ein System und Verfahren zur Kalibrierung von Mobilfunkgeräten wobei den Geräten Frequenz und Referenzpegelwerten vorgegeben werden.

Ein Schwellwertvergleich und die daraus hervorgehende Separierung defekter Mobilfunkgeräte kann bei rein prozessstatischen Prüfungen entfallen, bei denen die kontinuierlich gemessenen Werte der einzelnen Signalgrößen der von Mobilfunkgeräten gesendeten und/oder empfangenen Signale für eine Auswertung zu einem späteren Zeitpunkt lediglich archiviert werden.

Für beide Anwendungsfelder - Identifikation defekter Mobilfunkgeräte und prozessstatische Messung von Prozessparametern - ist neben einer hohen Präzision der Messung auch eine kurze Prüfzeit anzustreben. Die Prüfzeit macht sich dabei insbesondere bei Prüfungen negativ bemerkbar, bei denen das Mobilfunkgerät hinsichtlich mehrerer Signalgrößen des Sende- und Empfangssignals über eine Vielzahl von Sende- und Empfangsfrequenzen und über jeweils eine Vielzahl von Geräteparameterwerten von mehreren Geräteparametern geprüft werden muss.

Üblicherweise wird von einer übergeordneten Ablaufsteuerung die Frequenz und der Signalpegel des vom Mobilfunkgerät empfangenen Signals an das Messgerät und die Frequenz und der Signalpegel des vom Mobilfunkgerät gesendeten Signals zusammen mit den Geräteparameterwerten eines der im Mobilfunkgerät einzustellenden Geräteparameters an das Mobilfunkgerät übertragen und anschließend nach einer Triggerung mit darauf folgender Synchronisierung des Messgerätes mit dem Mobilfunkgerät die Messung der einzelnen relevanten Signalgrößen des Sende- und/oder Empfangssignals des Mobilfunkgeräts vom Messgerät erfasst.

Neben der eigentlichen Messzeit kommt nachteilig noch zusätzlich eine Übertragungszeit für die Übertragung der einzelnen Frequenzen und Signalpegel des zu prüfenden Empfangs- bzw. Sendesignals und der einzelnen Geräteparameterwerte von u.U. mehreren Geräteparametern des Mobilfunkgeräts hinzu, die die Gesamtzeit zur Messung aller Signalgrößen des gesendeten bzw. empfangenen Signals in allen Frequenzen deutlich erhöht.

Der Erfindung liegt deshalb die Aufgabe zugrunde, für die Prüfung eines Mobilfunkgeräts ein Verfahren und ein System zu schaffen, mit dem die gesamte Messzeit zur Prüfung der Abhängigkeit mehrerer Signalgrößen eines vom Mobilfunkgerät gesendeten oder empfangenen Signals von mehreren Geräteparameterwerten von u.U. mehreren Geräteparametern des Mobilfunkgerätes gegenüber dem Stand der Technik deutlich reduziert ist.

Die Aufgabe der Erfindung wird durch ein Verfahren zur Ermittlung der Abhängigkeit zwischen Geräteparametern eines Mobilfunkgeräts und Signalgrößen eines vom Mobilfunkgerät gesendeten und/oder empfangenen Signals mit den Merkmalen des Anspruchs 1 und durch ein System zur Ermittlung der Abhängigkeit zwischen Geräteparametern eines Mobilfunkgeräts und Signalgrößen eines vom Mobilfunkgerät gesendeten und/oder empfangenen Signals mit den Merkmalen des Anspruchs 17 gelöst. Vorteilhafte Weiterbildungen der Erfindung sind in den abhängigen Ansprüchen aufgeführt.

Im erfindungsgemäßen Verfahren und im erfindungsgemäßen System zur Ermittlung der Abhängigkeit zwischen Geräteparametern eines Mobilfunkgeräts und Signalgrößen eines vom Mobilfunkgerät gesendeten und/oder empfangenen Signals liegen sämtliche Frequenzen und Signalpegel des vom Mobilfunkgerät gesendeten und empfangenen Signals und sämtliche Geräteparameterwerte von allen im Mobilfunkgerät während der Typprüfung einstellbaren Geräteparametern bereits zu Beginn der Messungen im Mobilfunkgerät bzw, im Messgerät vor.

Diese Parameterwerte können im Mobilfunkgerät bzw. im Messgerät bereits vorab abgespeichert sein und nach Triggerung des Mobilfunkgeräts bzw. des Messgerätes über eine externe Triggerquelle vom Mobilfunkgerät bzw. vom Messgerät sukzessive im Ablauf der Typprüfung eingestellt werden.

Alternativ werden die einzelnen Parameterwerte von einer übergeordneten Ablaufsteuerung zu Beginn der Messungen in das Mobilfunkgerät bzw. in das Messgerät abgespeichert und nach erfolgreicher Abspeicherung die einzelnen Messungen mit Einstellung des ersten Parametersatzes gestartet.

Ein zwischen Mobilfunkgerät und Messgerät synchronisierter Prüfprozess wird durch die gleichzeitige Übertragung jeweils eines Synchronisiersignals an das Mobilfunkgerät und an das Messgerät durch die übergeordnete Ablaufsteuerung gewährleistet.

Bei insgesamt 4 Frequenzbändern, 10 Übertragungskanälen je Frequenzband und 5 Geräteparameterwerten eines Geräteparameters je Übertragungskanal verbessert sich die gesamte Messzeit von 30 bis 80 Sekunden nach dem Stand der Technik auf weniger als 1 Sekunde beim erfindungsgemäßen Verfahren und System zur Ermittlung der Abhängigkeit zwischen Geräteparametern eines Mobilfunkgeräts und Signalgrößen eines vom Mobilfunkgerät gesendeten und/oder empfangenen Signals.

Der Ablauf des erfindungsgemäßen Verfahrens kann in mehreren Ausführungsformen verwirklicht werden.

In einer ersten Ausführungsform des erfindungsgemäßen Verfahrens werden zu jeweils einer eingestellten Frequenz des gesendeten und empfangenen Signals und zu einem eingestellten Geräteparameterwert eines bestimmten Geräteparameters die einzelnen Signalgrößen des gesendeten Signals und unmittelbar darauf folgend die einzelnen Signalgrößen des empfangenen Signals erfasst.

In einer zweiten Ausführungsform des erfindungsgemäßen Verfahrens werden zu jeweils einer identisch eingestellten Frequenz des gesendeten und empfangenen Signals und zu einem eingestellten Geräteparameterwert eines bestimmten Gerätparameters die einzelnen Signalgrößen des gesendeten und empfangenen Signals simultan erfasst, indem über jeweils unterschiedliche Verbindungsleitungen das Messgerät ein der Frequenz und dem Signalpegel des Empfangssignals entsprechendes Testsignal dem Mobilfunkgerät und gleichzeitig das Mobilfunkgerät dem Messgerät ein Sendesignal sendet.

In einer dritten Ausführungsform des erfindungsgemäßen Verfahrens werden zuerst bei allen eingestellten Frequenzen des gesendeten Signals und bei allen eingestellten Geräteparameterwerten aller einzustellenden Geräteparameter die einzelnen Signalgrößen des gesendeten Signals und anschließend bei allen eingestellten Frequenzen des empfangenen Signals und bei allen eingestellten Geräteparameterwerten aller einzustellenden Geräteparameter die einzelnen Signalgrößen des empfangenen Signals zusammenhängend bzw. in umgekehrter Reihenfolge zusammenhängend erfasst.

In einer vierten Ausführungsform des erfindungsgemäßen Verfahrens werden zuerst bei einem jeweils eingestellten Frequenzwert des gesendeten und gleichzeitig des empfangenen Signal und bei allen eingestellten Geräteparameterwerten aller einzustellenden Geräteparameter die einzelnen Signalgrößen des gesendeten Signals und anschließend beim identisch eingestellten Frequenzwert bei allen eingestellten Geräteparameterwerten aller einzustellenden Geräteparameter die einzelnen Signalgrößen des empfangenen Signals zusammenhängend bzw. in umgekehrter Reihenfolge zusammenhängend erfasst, bevor anschließend bei einem weiteren Frequenzwert auf analoge Weise die einzelnen Signalgrößen des Sende- und Empfangsignals erfasst werden.

In einer ersten Unter-Ausführungsvariante der ersten, zweiten, dritten oder vierten Ausführungsform des erfindungsgemäßen Verfahrens werden für jeweils einen eingestellten Geräteparameterwert eines im Mobilfunkgerät einstellbaren Geräteparameters alle einstellbaren Frequenzen des Sende- und/oder Empfangssignals eingestellt und die zugehörigen, für die Typprüfung relevanten Signalgrößen des Sende- und/oder Empfangssignals gemessen, bevor sukzessive für die weiteren Geräteparameterwerte von allen einstellbaren Geräteparametern jeweils alle einstellbaren Frequenzen des Sende- und/oder Empfangssignals eingestellt und die zugehörigen Signalgröße des Sende- und/oder Empfangssignals gemessen werden.

In einer zweiten Unter-Ausführungsvariante der ersten, zweiten, dritten oder vierten Ausführungsform des erfindungsgemäßen Verfahrens werden für jeweils eine Frequenz des vom Mobilfunkgerät gesendeten und/oder empfangenen Signales alle einstellbaren Geräteparameterwerte der für die Prüfung einstellbaren Geräteparameter eingestellt und die zugehörigen, für die Typprüfung relevanten Signalgrößen des Sende- und/oder Empfangssignals gemessen, bevor sukzessive für die weiteren einstellbaren Frequenzen des Sende- und/oder Frequenzsignals alle einstellbaren Geräteparameterwerte von allen einstellbaren Geräteparametern eingestellt und die zugehörigen Signalgrößen des Sende- und/oder Empfangssignals gemessen werden.

Die Variation der Geräteparameterwerte jedes im Mobilfunkgerät einstellbaren Geräteparameters werden aus Effizienzgründen entweder dekrementierend oder inkrementierend eingestellt.

Für die Messung der einzelnen Signalgrößen des Sende- oder Empfangssignals oder bei simultaner Messung des Sende- oder Empfangssignals ist jeweils ein Zeitschlitz (slot) vorgesehen. Die Zeitschlitze der einzelnen Messungen sind entweder unmittelbar aufeinander folgend oder durch jeweils einen oder mehrere Zeitschlitze ohne Messung einer Signalgröße des Sende- oder Empfangssignals getrennt angeordnet.

Bei Variation der einstellbaren Frequenz des Sende- und/oder Empfangssignals kann jeweils ein Zeitschlitz ohne Messung einer der Signalgrößen des Sende- und/oder Empfangssignals vorgesehen sein.

Bei einer ersten Ausführungsform des erfindungsgemäßen Systems wird Messgerät und Mobilfunkgerät von einer übergeordneten Einheit zur Ablaufsteuerung zu Beginn der Messungen initialisiert, getriggert und synchronisiert und am Ende der Messungen eine Auswertung der gemessenen Werte durchgeführt.

Die zweite Ausführungsform des erfindungsgemäßen Systems ermöglicht ohne Zwischenschaltung einer übergeordneten Einheit zur Ablaufsteuerung eine Initialisierung, Triggerung, Synchronisierung und Messung der Signalgrößen von Sende- und/oder Empfangssignal zwischen Messgerät und Mobilfunkgerät über zwei Übertragungskanäle.

Die dritte Ausführungsform des erfindungsgemäßen Systems ermöglicht ohne Zwischenschaltung einer übergeordneten Einheit zur Ablaufsteuerung eine Initialisierung, Triggerung, Synchronisierung und Messung der Signalgrößen von Sende- und/oder Empfangssignal zwischen Messgerät und Mobilfunkgerät über einen Übertragungskanal.

Die erste Ausführungsform eines erfindungsgemäßen Systems zur parallelen Ermittlung der Abhängigkeit zwischen Geräteparametern mehrerer Mobilfunkgeräte und Signalgrößen des vom jeweiligen Mobilfunkgerät gesendeten und/oder empfangenen Signals ermöglicht über jeweils n Messeinheiten, n Schnittstellen und n Verbindungsleitungen die Messung der Signalgrößen des Sende- und Empfangssignals von insgesamt n Mobilfunkgeräten.

Die zweite Ausführungsform eines erfindungsgemäßen Systems zur parallelen Ermittlung.der Abhängigkeit zwischen Geräteparametern mehrerer Mobilfunkgeräte und Signalgrößen des vom jeweiligen Mobilfunkgerät empfangenen Signals ermöglicht über jeweils 1 Messeinheit, 1 Schnittstelle und n Verbindungsleitungen die Messung der Signalgrößen des Empfangssignals von insgesamt n Mobilfunkgeräten.

Ausführungsformen des erfindungsgemäßen Verfahrens und Systems zur Ermittlung der Abhängigkeit zwischen Geräteparametern eines Mobilfunkgeräts und Signalgrößen eines vom Mobilfunkgerät gesendeten und/oder empfangenen Signals werden im folgenden unter Bezugnahme auf die Zeichnung näher erläutert. In der Zeichnung zeigen:
- Fig. 1: ein Blockschaltbild einer ersten Ausfüh- rungsform eines erfindungsgemäßen Systems zur Ermittlung der Abhängigkeit zwischen Geräteparametern eines Mobilfunkgeräts und Signalgröße eines vom Mobilfunkgerät gesendeten und/oder empfangenen Signals,
- Fig. 2: ein Flussdiagramm einer ersten Unter- Ausführungsvariante einer ersten Ausfüh- rungsform des erfindungsgemäßen Verfahrens zur Ermittlung der Abhängigkeit zwischen Geräteparametern eines Mobilfunkgeräts und Signalgrößen eines vom Mobilfunkgerät gesendeten und/oder empfangenen Signals,
- Fig. 3: ein Flussdiagramm einer zweiten Unter- Ausführungsvariante einer ersten Ausfüh- rungsform des erfindungsgemäßen Verfahrens zur Ermittlung der Abhängigkeit zwischen Geräteparametern eines Mobilfunkgeräts und Signalgrößen eines vom Mobilfunkgerät gesendeten und/oder empfangenen Signals,
- Fig. 4: ein Flussdiagramm einer zweiten Ausfüh- rungsform des erfindungsgemäßen Verfahrens zur Ermittlung der Abhängigkeit zwischen Geräteparametern eines Mobilfunkgeräts und Signalgrößen eines vom Mobilfunkgerät ge- sendeten und/oder empfangenen Signals,
- Fig. 5: ein Flussdiagramm einer dritten Ausfüh- rungsform des erfindungsgemäßen Verfahrens zur Ermittlung der Abhängigkeit zwischen Geräteparametern eines Mobilfunkgeräts und Signalgrößen eines vom Mobilfunkgerät ge- sendeten und empfangenen Signals,
- Fig. 6: ein Flussdiagramm einer vierten Ausfüh- rungsform des erfindungsgemäßen Verfahrens zur Ermittlung der Abhängigkeit zwischen Geräteparametern eines Mobilfunkgeräts und Signalgrößen eines vom Mobilfunkgerät ge- sendeten und empfangenen Signals,
- Fig. 7: ein Zeitdiagramm der ersten Ausführungsform des erfindungsgemäßen Verfahrens zur Er- mittlung der Abhängigkeit zwischen Geräte- parametern eines Mobilfunkgeräts und Sig- nalgrößen eines vom Mobilfunkgerät em- pfangenen Signals,
- Fig. 8: ein Zeitdiagramm der ersten Ausführungsform des erfindungsgemäßen Verfahrens zur Er- mittlung der Abhängigkeit zwischen Geräte- parametern eines Mobilfunkgeräts und Sig- nalgrößen eines vom Mobilfunkgerät gesen- deten Signals,
- Fig. 9: ein Zeitdiagramm mehrerer in einem Zeit- rahmen direkt aufeinander folgender Zeitschlitze,
- Fig. 10: ein Zeitdiagramm mehrerer in einem Zeit- rahmen beabstandeter Zeitschlitze,
- Fig. 11: ein Zeitdiagramm mehrerer durch jeweils einen Zeitschlitz getrennter Zeitrahmen,
- Fig. 12: ein Blockschaltbild einer zweiten Ausfüh- rungsform eines erfindungsgemäßen Systems zur Ermittlung der Abhängigkeit zwischen Geräteparametern eines Mobilfunkgeräts und Signalgrößen eines vom Mobilfunkgerät ge- sendeten und/oder empfangenen Signals,
- Fig. 13: ein Blockschaltbild einer dritten Ausfüh- rungsform eines erfindungsgemäßen Systems zur Ermittlung der Abhängigkeit zwischen Geräteparametern eines Mobilfunkgeräts und Signalgrößen eines vom Mobilfunkgerät ge- sendeten und/oder empfangenen Signals,
- Fig. 14: ein Blockschaltbild einer ersten Ausfüh- rungsform eines erfindungsgemäßen Systems zur parallelen Ermittlung der Abhängigkeit zwischen Geräteparametern mehrerer Mobil- funkgeräte und Signalgröße des vom jewei- ligen Mobilfunkgerät gesendeten und/oder empfangenen Signals und
- Fig. 15: ein Blockschaltbild einer zweiten Ausfüh- rungsform eines erfindungsgemäßen Systems zur parallelen Ermittlung der Abhängigkeit zwischen Geräteparametern mehrerer Mobil- funkgeräte und Signalgrößen des vom jewei- ligen Mobilfunkgerät empfangenen Signals.

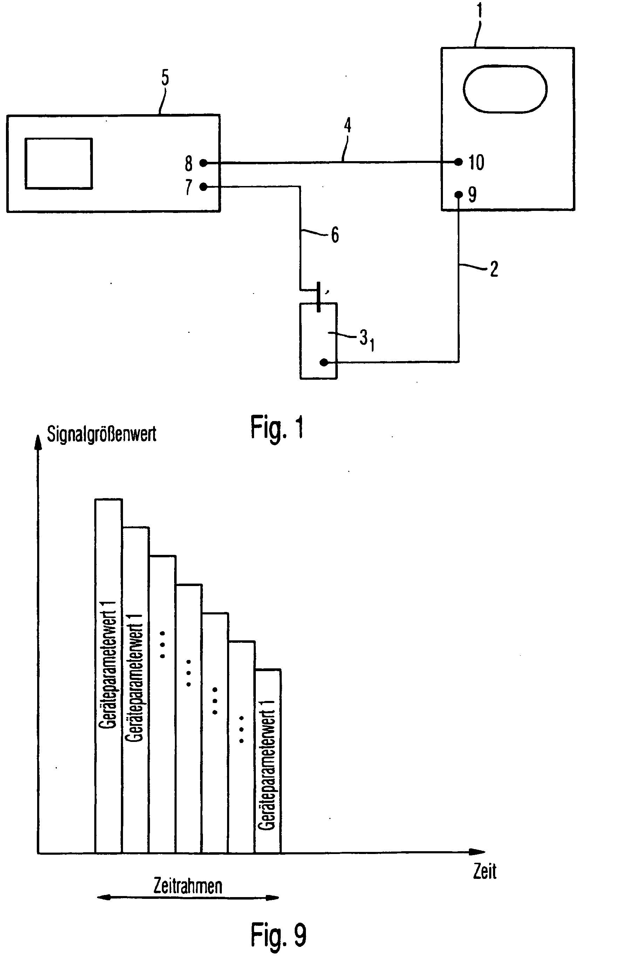

Ausgehend von Fig. 1, in der das Blockschaltbild einer ersten Unterausführungsvariante der ersten Ausführungsform des erfindungsgemäßen Systems zur Ermittlung der Abhängigkeit zwischen Geräteparametern eines Mobilfunkgerätes und Signalgrößen eines vom Mobilfunkgerät gesendeten und/oder empfangenen Signals dargestellt ist, wird im folgenden die erste Unterausführungsvariante der ersten Ausführungsform des erfindungsgemäßen Verfahrens zur Ermittelung der Abhängigkeit zwischen Geräteparametern eines Mobilfunkgerätes und Signalgrößen eines vom Mobilfunkgerät gesendeten und/oder empfangenen Signals beschrieben:

In Verfahrensschritt S10 des erfindungsgemäßen Verfahrens werden der Signalpegel und die zu festgelegten Sendekanälen in den einzelnen Frequenzbändern gehörigen Frequenzen des Sendesignals des Mobilfunkgeräts sowie die zu einzelnen Geräteparametern gehörigen, einzustellenden Geräteparameterwerte von der Einheit zur übergeordneten Ablaufsteuerung 1 über die Schnittstelle 9 und die Verbindungsleitung 2 zum Mobilfunkgerät 3₁ und der Signalpegel und die zu festgelegten Empfangskanälen in den einzelnen Frequenzbändern gehörigen Frequenzen des Empfangssignals des Mobilfunkgeräts über die Schnittstelle 10 und die Verbindungsleitung 4 zum Messgerät 5 übertragen. Diese Datenübertragungen zum Mobilfunkgerät 3₁ und Messgerät 5 können entweder in einer Vorphase der Messungen oder zu Beginn der Messungen erfolgen.

Im darauf folgenden Verfahrensschritt S20 erfolgt der Start der Messungen durch Triggerung des Mobilfunkgeräts 3₁ und des Messgerätes 5. Bei einer Datenübertragung zu Beginn der Messungen erfolgt die Triggerung des Mobilfunkgeräts 3₁ und des Messgerätes 5 durch das Ereignis der Datenübertragung. Sind die Daten bereits übertragen worden und liegen im Mobilfunkgerät 3₁ und im Messgerät 5 vor, so müssen die einzelnen Messungen durch ein zusätzliches externes Triggersignal von der Einheit zur übergeordneten Ablaufsteuerung 1 gestartet werden. Zusätzlich erfolgt in Verfahrenschritt S20 die Übertragung eines Synchronisiersignals von der Einheit zur übergeordneten Ablaufsteuerung 1 an das Mobilfunkgerät 3₁ und an das Messgerät 5. Auf diese Weise ist das Mobilfunkgerät 3₁ mit dem Messgerät 5 sowie mit der Einheit zur übergeordneten Ablaufsteuerung 1 selbstsynchronisiert. Eine zusätzliche Vorrichtung - eine zusätzliche Trigger- bzw. Synchronisier-Einheit - zur kontinuierlichen Synchronisierung des Messgerätes 5 mit dem Mobilfunkgerät 3₁ ist in diesem Fall nicht erforderlich.

Die erste Messung wird in Verfahrensschritt S30 mit der Einstellung des Signalpegels und des ersten Frequenzwertes des Sendesignals sowie des ersten Geräteparameterwertes für den ersten einzustellenden Geräteparameter im Mobilfunkgerät 3₁ und der Einstellung des Signalpegels und des ersten Frequenzwertes eines Testsignals im Messgerät 5, das als Empfangssignal vom Mobilfunkgerät 3₁ empfangen wird, vorbereitet.

Im nächsten Verfahrensschritt S40 wird das im vorherigen Verfahrensschritt S30 vorbereitete Sendesignal vom Mobilfunkgerät 3₁ über die Verbindungsleitung 6 zum Messgerät 5 gesendet. Dieses Sendesignal wird vom Messgerät 5 an dessen Schnittstelle 7 hinsichtlich einer oder mehrerer Signalgrößen - Signalpegel, Frequenz, Phase u.s.w. - erfasst. Über eine im Messgerät 5 implementierte Signalverarbeitung werden aus den gemessenen Signalgrößen weitere zusammengesetzte Signalgrößen - beispielsweise EMV, CDP u.s.w. - ermittelt. Als Messzeit zur Erfassung einer Signalgröße ist gemäß Fig. 9 jeweils ein Zeitschlitz (slot) innerhalb eines Zeitrahmens (frame) vorgesehen.

Analog sendet das Messgerät 5 im nächsten Verfahresschritt S50 das in Verfahrensschritt S30 vorbereitete, dem Empfangssignal entsprechende Testsignal über dieselbe Schnittstelle 7 und dieselbe Verbindungsleitung 6 an das Mobilfunkgerät 3₁. Das vom Messgerät 5 gesendete Testsignal wird vom Mobilfunkgerät 3₁ als Empfangssignal empfangen und hinsichtlich einer oder mehrerer Signalgrößen erfasst, aus denen über eine Signalverarbeitung weitere zusammengesetzte Signalgrößen im Mobilfunkgerät 3₁ ermittelt werden.

Im darauf folgenden Verfahrensschritt S60 wird der nächste Geräteparameterwert des ersten Geräteparameters im Mobilfunkgerät 3₁ eingestellt und die Messung der zu diesem Geräteparameterwert des ersten Geräteparameters gehörigen Signalgrößen des Sende- und Empfangssignals in den Verfahrensschritten S40 und S50 gemessen bzw. ermittelt.

Sind die zu allen Geräteparameterwerten des ersten Geräteparameters gehörigen Signalgrößen des Sende- und Empfangssignals erfasst worden, so wird in Verfahrensschritt S60 der erste Geräteparameterwert des nächsten Geräteparameters im Mobilfunkgerät 3₁ eingestellt und die zugehörigen Signalgrößen des Sende- und Empfangssignals in den Verfahrensschritten S40 und S50 ermittelt.

Sobald alle Geräteparameterwerte jedes Geräteparameters eingestellt und die zugehörigen Signalgrößen des Sende- und Empfangssignals gemessen worden sind, wird im nächsten Verfahrensschritt S70 der nächste Frequenzwert des Sende- und Empfangssignals vom Messgerät 5 bzw. vom Mobilfunkgerät 3₁ und wieder der erste Geräteparameterwert des ersten Geräteparameters im Mobilfunkgerät 3₁ eingestellt, um damit die beim nächsten Frequenzwert des Sende- und Empfangssignals und beim ersten Geräteparameterwert des ersten Geräteparameters sich einstellenden Signalgrößen des Sende- und Empfangssignals in den Verfahrensschritten S40 und S50 erneut zu erfassen.

Sind schließlich für alle Frequenzwerte und für jeden Geräteparameterwert jedes Geräteparameters die jeweils zugehörigen Signalgrößen des Sende- und Empfangssignals im Mobilfunkgerät 3₁ und dem Messgerät 5 erfasst worden, so können in einem optionalen Verfahrensschritt S80 die einzelnen gemessenen Signalgrößen des Sende- und Empfangssignals hinsichtlich ihrer Korrektheit geprüft werden. Hierzu werden die einzelnen gemessenen Signalgrößen des Sende- und Empfangssignals typischerweise vom Mobilfunkgerät 3₁ über die Verbindungsleitung 2 und die Schnittstelle 9 und vom Messgerät 5 über die Schnittstelle 8, die Verbindungsleitung 4 und die Schnittstelle 10 der Einheit zur übergeordneten Ablaufsteuerung 1 zugeführt und mit jeweils zwei den Toleranzbereich der jeweiligen Signalgröße definierenden Schwellwerten verglichen, die in der Einheit zur übergeordneten Ablaufsteuerung 1 abgespeichert sind.

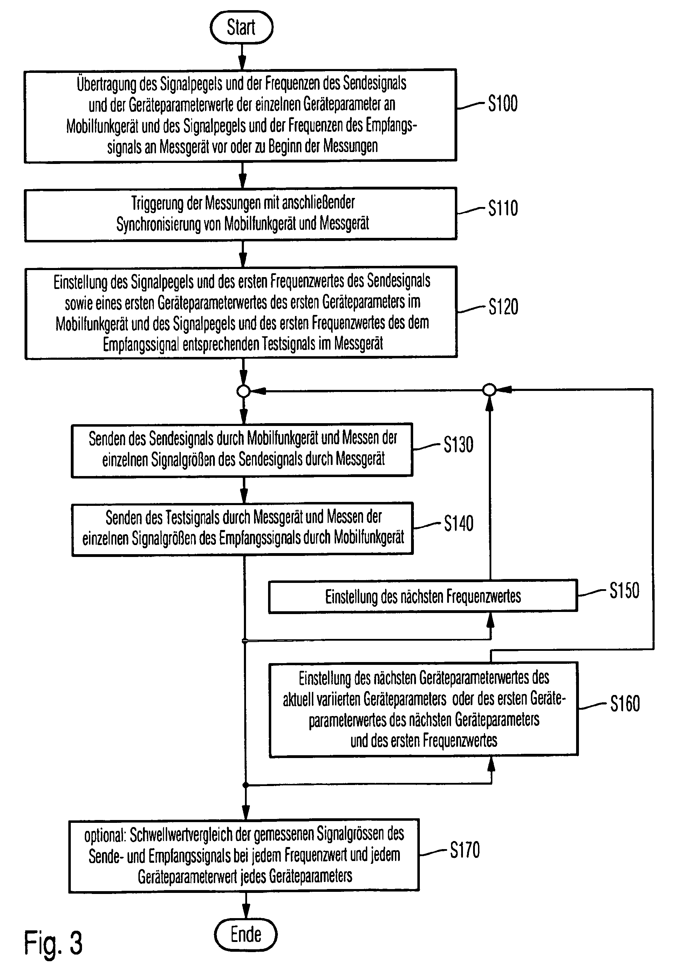

Einer zweiten Unterausführungsvariante der ersten Ausführungsform des erfindungsgemäßen Verfahrens zur Ermittlung der Abhängigkeit zwischen Geräteparametern eines Mobilfunkgerätes und Signalgrößen eines vom Mobilfunkgerät gesendeten und/oder empfangenen Signals, deren Flussdiagramm in Fig. 3 dargestellt ist, werden in Abgrenzung zur ersten Unterausführungsvariante der ersten Ausführungsform des erfindungsgemäßen Verfahrens anstelle der Variation der einzelnen Geräteparameterwerte der einzelnen Geräteparameter in Verfahrensschritt S60 zuerst die einzelnen Frequenzwerte in Verfahrensschritt S150 und anschließend anstelle der Variation der einzelnen Frequenzwerte in Verfahrensschritt S70 die einzelnen Geräteparameterwerte der einzelnen Geräteparameter in Verfahrensschritt S160 durchgestimmt.

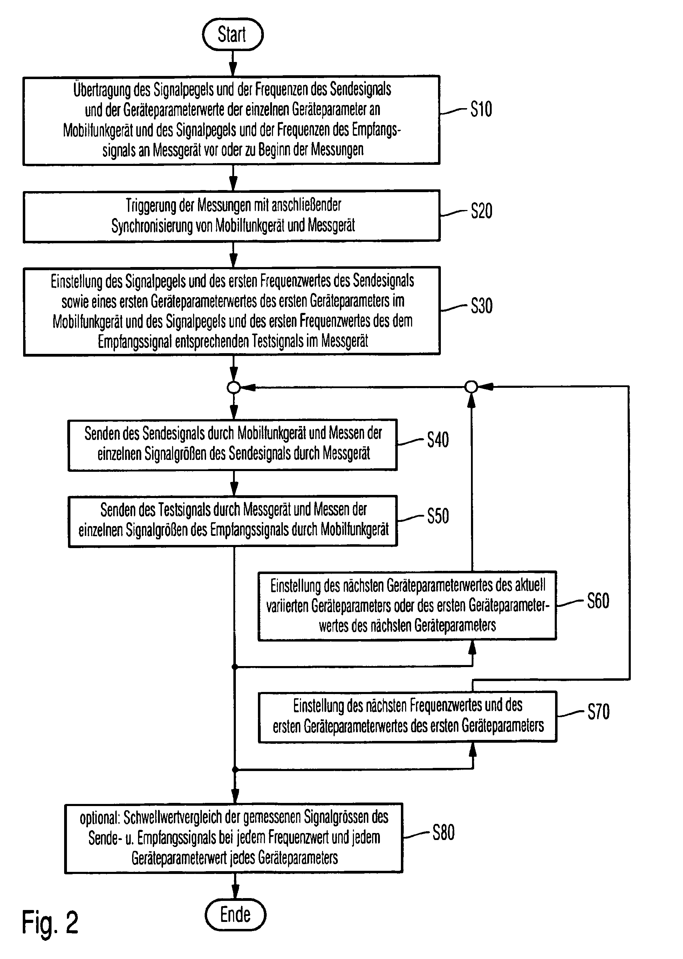

Die übrigen Verfahrensschritten S100, S110, S120, S130, S140 und S170 der zweiten Unterausführungsvariante der ersten Ausführungsform des erfindungsgemäßen Verfahrens in Fig. 3 entsprechen den Verfahrensschritten S10, S20, S30, S40, S50 und S80 der ersten Unterausführungsvariante der ersten Ausführungsform des erfindungsgemäßen Verfahrens in Fig. 2 und werden deshalb nicht mehr beschrieben.

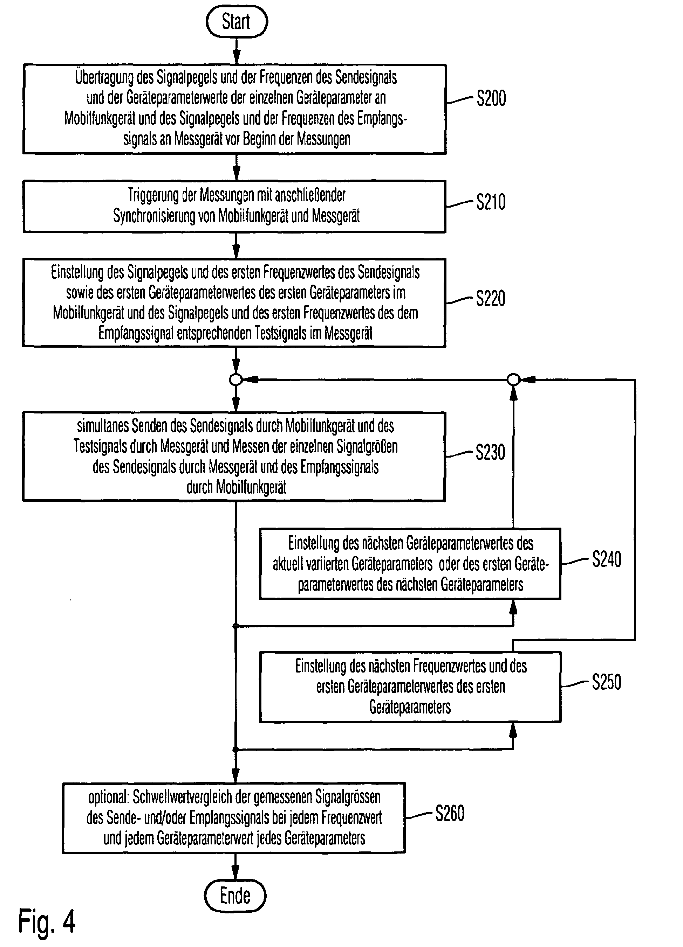

Bei der zweiten Ausführungsform des erfindungsgemäßen Verfahrens zur Ermittlung der Abhängigkeit zwischen Geräteparametern eines Mobilfunkgerätes und Signalgrößen eines vom Mobilfunkgerät gesendeten und/oder empfangenen Signals in Fig. 4 werden die einzelnen Signalgrößen jeweils eines Sende- und Empfangssignals simultan innerhalb jeweils eines Zeitschlitzes gemessen.

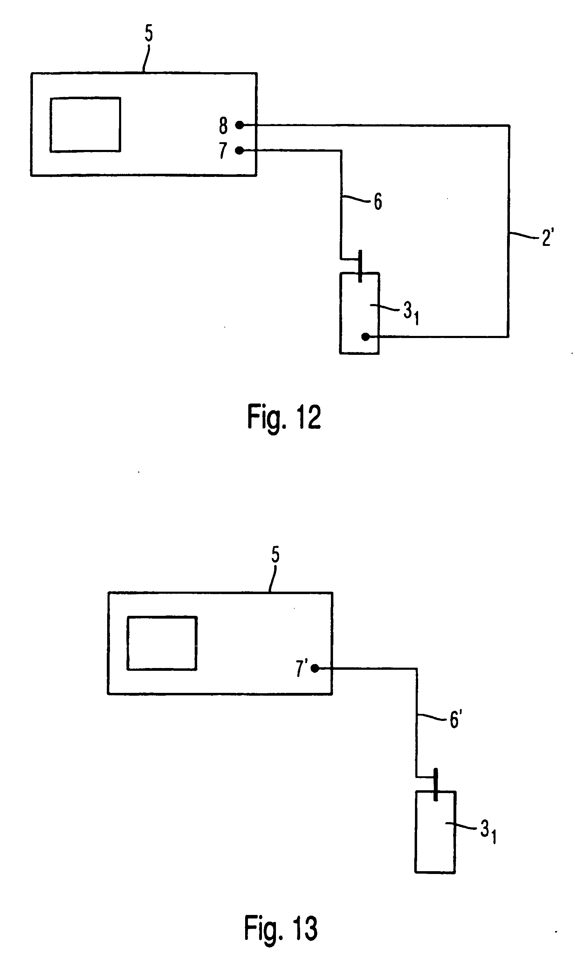

Für die simultanen Messungen zwischen dem Mobilfunkgerät 3₁ und dem Messgerät 5 sind zwei Verbindungsleitungen 2' und 6 gemäß der zweiten Ausführungsform des erfindungsgemäßen Systems zur Ermittlung der Abhängigkeit zwischen Geräteparametern eines Mobilfunkgeräts und Signalgrößen eines vom Mobilfunkgerät gesendeten und/oder empfangenen Signals in Fig. 12 erforderlich.

Auf eine Einheit zur übergeordneten Ablaufsteuerung 1 wird bei der zweiten Ausführungsform des erfindungsgemäßen Systems verzichtet. Die Abspeicherung der Signalpegel und der einzelnen Frequenzwerte des Sende- und Empfangssignals sowie der einzelnen Geräteparameterwerte der einzelnen Geräteparameter im Mobilfunkgerät 3₁ muss deshalb schon vor Beginn der Messungen im Messgerät 5 und im Mobilfunkgerät 3₁ durchgeführt werden. Der Start der Messungen erfolgt durch gegenseitige Triggerung und gegenseitige Synchronisierung zwischen Mobilfunkgerät 3₁ und Messgerät 5.

Bei der ersten Unterausführungsvariante der zweiten Ausführungsform des erfindungsgemäßen Verfahrens zur Ermittlung der Abhängigkeit zwischen Geräteparametern eines Mobilfunkgerätes und Signalgrößen eines vom Mobilfunkgerät gesendeten und/oder empfangenen Signals werden die Verfahrensschritte S40 und S50, in denen für jeden eingestellten Signalpegel und jede eingestellte Frequenz des Sende- und Empfangssignals sowie jeden eingestellten Geräteparameterwert der einzelnen einzustellenden Geräteparameter die einzelnen Signalgrößen des Sende- und Empfangssignals gemessen werden, zu einem Verfahrenschritt S230 zusammengefasst, in dem das Sendesignal vom Mobilfunkgerät 3₁ gesendet und vom Messgerät 5 gemessen wird und simultan das dem Empfangssignal entsprechende Testsignal vom Messgerät 5 gesendet und vom Mobilfunkgerät 3₁ als Empfangssignal gemessen wird.

Die Verfahrensschritte S200, S210, S220, S240, S250 und S260 der ersten Unterausführungsvariante der zweiten Ausführungsform des erfindungsgemäßen Verfahrens in Fig. 4 entsprechen den Verfahrensschritten S10, S20, S30, S60, S70 und S80 der ersten Unterausführungsvariante der ersten Ausführungsform des erfindungsgemäßen Verfahrens in Fig. 2 und werden deshalb nicht mehr beschrieben.

Die zweite Unterausführungsvariante der zweiten Ausführungsform des erfindungsgemäßen Verfahrens zur Ermittlung der Abhängigkeit zwischen Geräteparametern eines Mobilfunkgerätes und Signalgrößen eines vom Mobilfunkgerät gesendeten und/oder empfangenen Signals, bei der Sende- und Empfangssignal simultan gemessen werden und in einer ersten Iterationsschleife die einzelnen Frequenzwerte durchgestimmt werden und in einer der ersten Iterationsschleife überlagerten, zweiten Iterationsschleife die einzelnen Geräteparameterwerte der einzelnen Geräteparameter durchgestimmt werden, ergibt sich aus einer Kombination der Verfahrensschritte S200, S210, S220, S230 der ersten Unterausführungsvariante der zweiten Ausführungsform des erfindungsgemäßen Verfahrens in Fig. 4 mit den Verfahrensschritten S150 und S160 der zweiten Unterausführungsvariante der ersten Ausführungsform des erfindungsgemäßen Verfahrens in Fig. 3 und wird deshalb in keiner weiteren Figur der Zeichnung dargestellt und im Detail beschrieben.

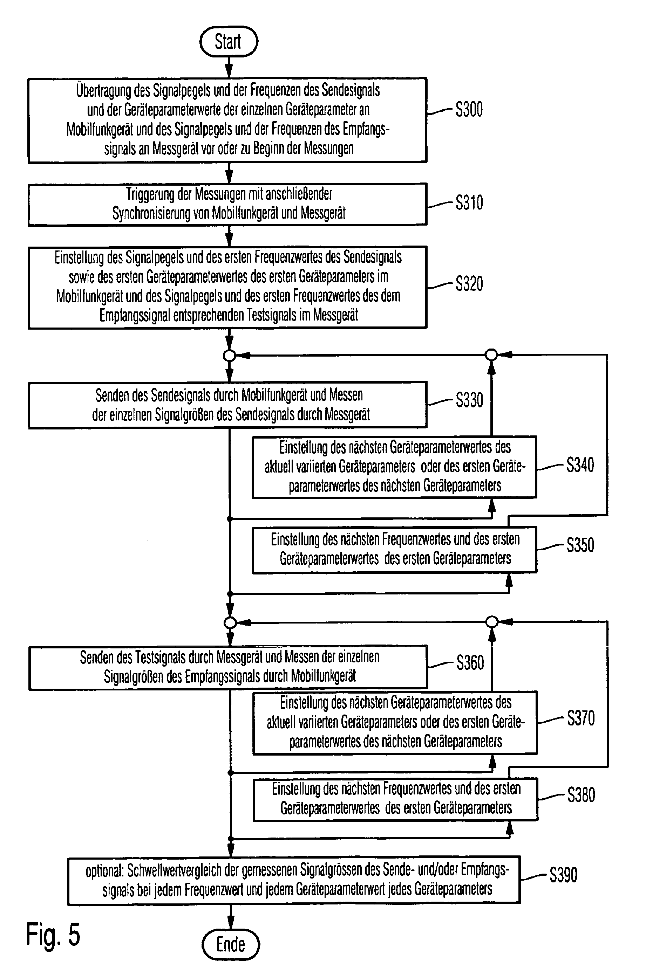

Bei der ersten Unterausführungsvariante der dritten Ausführungsform des erfindungsgemäßen Verfahrens zur Ermittlung der Abhängigkeit zwischen Geräteparametern eines Mobilfunkgerätes und Signalgrößen eines vom Mobilfunkgerät gesendeten und/oder empfangenen Signals in Fig. 5 werden für jeden eingestellten Signalpegel und jede eingestellte Frequenz sowie für jeden eingestellten Geräteparameterwert jedes im Mobilfunkgerät 3₁ einstellbaren Geräteparameters zuerst die einzelnen zugehörigen Signalgrößen des Sendesignals und anschließend die einzelnen zugehörigen Signalgrößen des Empfangssignals gemessen.

Die Verfahrensschritte S300, S310, S320, S330, S340, S350 und S390 der ersten Unterausführungsvariante der dritten Ausführungsform des erfindungsgemäßen Verfahrens in Fig. 5 entsprechen dabei den Verfahrensschritten S10, S20, S30, S40, S50, S60, S70 und S80 der ersten Unterausführungsvariante der ersten Ausführungsform des erfindungsgemäßen Verfahrens in Fig. 2 und werden deshalb nicht mehr beschrieben. Die Verfahrensschritte S360, S370 und S380 der ersten Unterausführungsvariante der dritten Ausführungsform des erfindungsgemäßen Verfahrens, die sich auf die Variation der einzelnen Frequenzen und der einzelnen Geräteparameterwerte der einzelnen einstellbaren Geräteparameter und auf das Messen der einzelnen Signalgrößen des Empfangssignals beziehen, entsprechen den Verfahrensschritten S330, S340 und S350 für die Variation der einzelnen Frequenzen und einzelnen Geräteparameterwerte der einzelnen einstellbaren Geräteparameter und für das Messen der einzelnen Signalgrößen des Sendesignals.

Die erste Unterausführungsvariante der dritten Ausführungsform des erfindungsgemäßen Verfahrens, bei der zuerst die einzelnen Signalgrößen des Empfangssignals und anschließend die einzelnen Signalgrößen des Sendesignals gemessen werden, führt lediglich zu einer Vertauschung der Verfahrensschritte S330 bis S350 mit den Verfahrensschritten S360 bis S380 im Flussdiagramm der Fig. 5.

Die zweite Unterausführungsvariante der dritten Ausführungsform des erfindungsgemäßen Verfahrens zur Ermittlung der Abhängigkeit zwischen Geräteparametern eines Mobilfunkgeräts und Signalgrößen eines vom Mobilfunkgerät gesendeten und/oder empfangenen Signals, bei der für das Messen der einzelnen Signalgrößen des Sende- und Empfangssignals zuerst die einzelnen Frequenzwerte jeweils in einer Iterationsschleife durchgestimmt werden und anschließend in einer der ersten Iterationsschleife überlagerten, zweiten Iterationsschleife die einzelnen Geräteparameterwerte der einzelnen einstellbaren Geräteparameter durchgestimmt werden, ergibt sich durch Vertauschen der Reihenfolge der Verfahrensschritte S340 mit S350 und der Verfahrensschritte S370 mit S380.

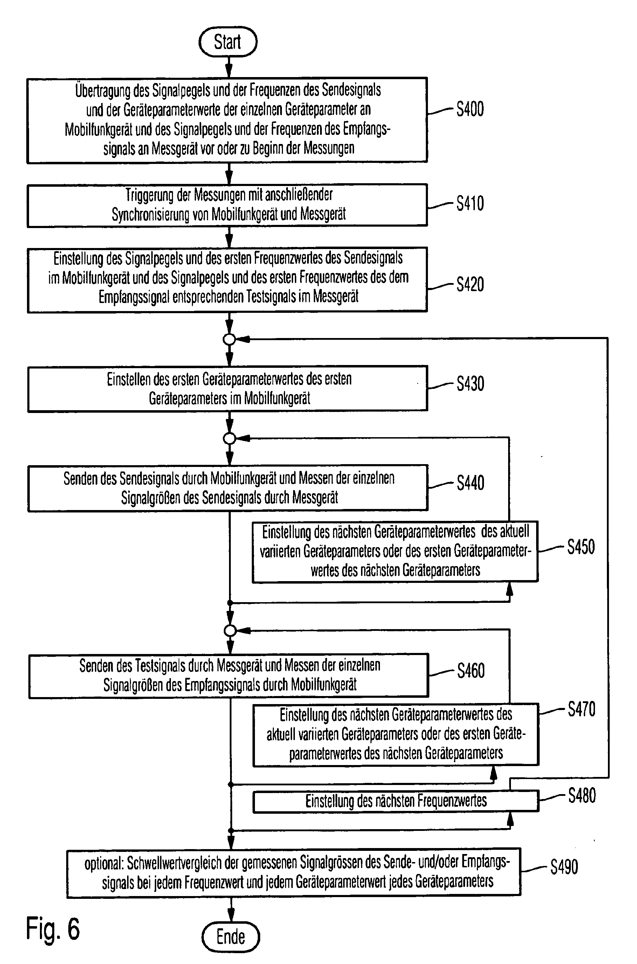

In der ersten Unterausführungsvariante der vierten Ausführungsform des erfindungsgemäßen Verfahrens zur Ermittlung der Abhängigkeit zwischen Geräteparametern eines Mobilfunkgerätes und Signalgröße eines vom Mobilfunkgerät gesendeten und/oder empfangenen Signals in Fig. 6 werden zuerst die einzelnen Signalgrößen des Sendesignals zu jeweils durchgestimmten Geräteparameterwerten der einzelnen Geräteparameter und anschließend die einzelnen Signalgrößen des Empfangssignals zu jeweils durchgestimmten Geräteparameterwerten der einzelnen Geräteparameter in Analogie zur ersten Unterausführungsvariante der dritten Ausführungsform des erfindungsgemäßen Verfahrens in Fig. 5 gemessen, bevor in einer weiteren Iterationsschleife die einzelnen Frequenzwerte für die Messung der einzelnen Signalgrößen des Sende- als auch des Empfangssignals gemeinsam durchgestimmt werden. Die Verfahrensschritte S350 und S380 der ersten Unterausführungsvariante der dritten Ausführungsform des erfindungsgemäßen Verfahrens zur Variation der einzelnen Frequenzwerte gehen folglich in einen einzigen Verfahrensschritt S480 in der ersten Unterausführungsvariante der vierten Ausführungsform des erfindungsgemäßen Verfahrens über. Die Verfahrensschritte S400, S410, S440, S450, S460, S470 und S480 der ersten Unterausführungsvariante der vierten Ausführungsform des erfindungsgemäßen Verfahrens entsprechen dabei den Verfahrensschritten S300, S310, S330, S340, S360, S370 und S380 der ersten Unterausführungsvariante der dritten Ausführungsform des erfindungsgemäßen Verfahrens und werden deshalb nicht mehr beschrieben. Der Inhalt des Verfahrensschritts S320 der ersten Unterausführungsvariante der dritten Ausführungsform des erfindungsgemäßen Verfahrens wird in die beiden Verfahrensschritte S440 und S450 der ersten Unterausführungsvariante der vierten Ausführungsform des erfindungsgemäßen Verfahrens aufgeteilt.

Die erste Unterausführungsvariante der vierten Ausführungsform des erfindungsgemäßen Verfahrens, bei der zuerst die einzelnen Signalgrößen des Empfangssignals und anschließend die einzelnen Signalgrößen des Sendesignals gemessen werden, führt lediglich zu einer Vertauschung der Verfahrensschritte S440 bis S450 mit den Verfahrensschritten S470 bis S480 im Flussdiagramm der Fig. 6.

Die zweite Unterausführungsvariante der vierten Ausführungsform des erfindüngsgemäßen Verfahrens zur Ermittlung der Abhängigkeit zwischen Geräteparametern eines Mobilfunkgeräts und Signalgrößen eines vom Mobilfunkgerät gesendeten und/oder empfangenen Signals, bei der für das Messen der einzelnen Signalgrößen des Sende- und Empfangssignals die einzelnen Frequenzwerte jeweils in einer Iterationsschleife durchgestimmt werden und anschließend in einer der ersten Iterationsschleife überlagerten, zweiten Iterationsschleife die einzelnen Geräteparameterwerte der einzelnen einstellbaren Geräteparameter durchgestimmt werden, ergibt sich durch Vertauschung der Inhalte der Verfahrensschritte S450 bzw. S470 mit dem Inhalt des Verfahrenschritts S480 der ersten Unterausführungsvariante der vierten Ausführungsform des erfindungsgemäßen Verfahrens.

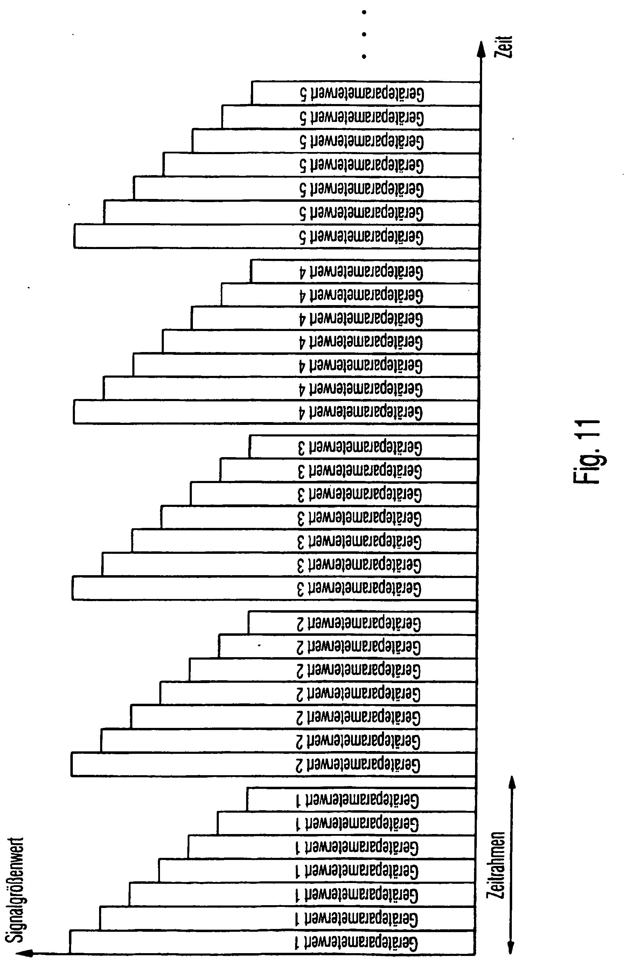

Die für einen Übertragungskanal bei einem bestimmten Frequenzwert jeweils durchzuführenden Messungen der einzelnen Signalgrößen des Sende- oder Empfangssignals werden gemäß Fig. 11 in einem Zeitrahmen (frame) bestehend aus mehreren Zeitschlitzen für jeweils einen der durchzustimmenden Geräteparameterwerte eines bestimmten Geräteparameters angeordnet. Sind Geräteparameterwerte eines weiteren durchzustimmenden Geräteparameters für die Messung der einzelnen Signalgrößen des Sende- und Empfangssignals durchzustimmen oder sind die Geräteparameterwerte eines durchzustimmenden Geräteparameters für einen weiteren Frequenzwert des Sende- oder Empfangssignals durchzustimmen, so wird gemäß Fig. 11 ein weiterer Zeitrahmen mit neu durchzustimmenden Geräteparameterwerten eines bestimmten Geräteparameters angeordnet, der von einem Zeitschlitz ohne Messung vom vorherigen Zeitrahmen zeitlich getrennt ist.

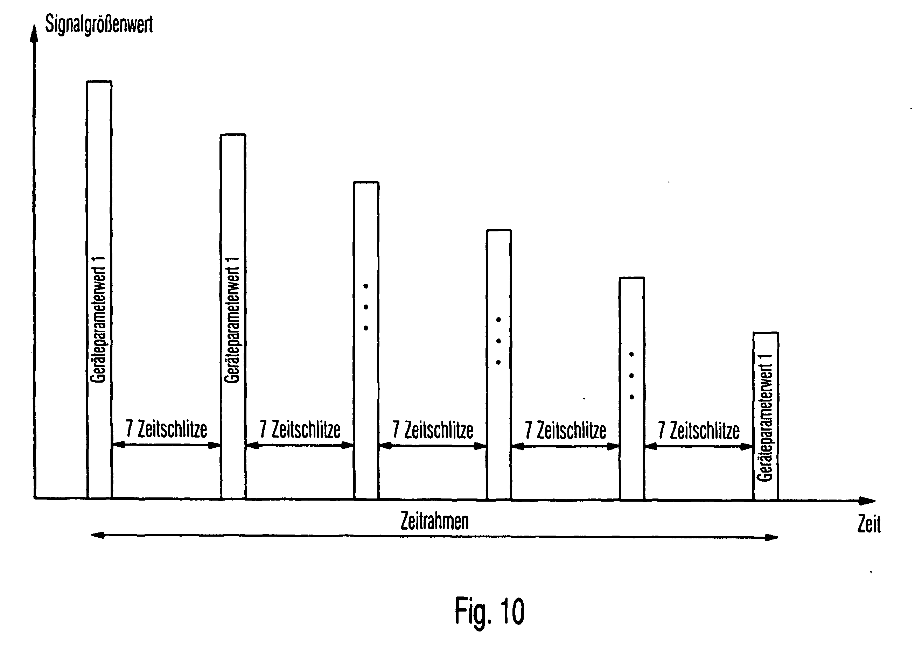

Die Messungen der einzelnen Signalgrößen des Sende- oder Empfangssignals in der einzelnen Zeitschlitzen eines Zeitrahmens können entweder gemäß Fig. 9 unmittelbar aufeinander folgen oder gemäß Fig. 10 durch jeweils einen oder mehrere Zeitschlitze ohne Messungen voneinander beabstandet sein.

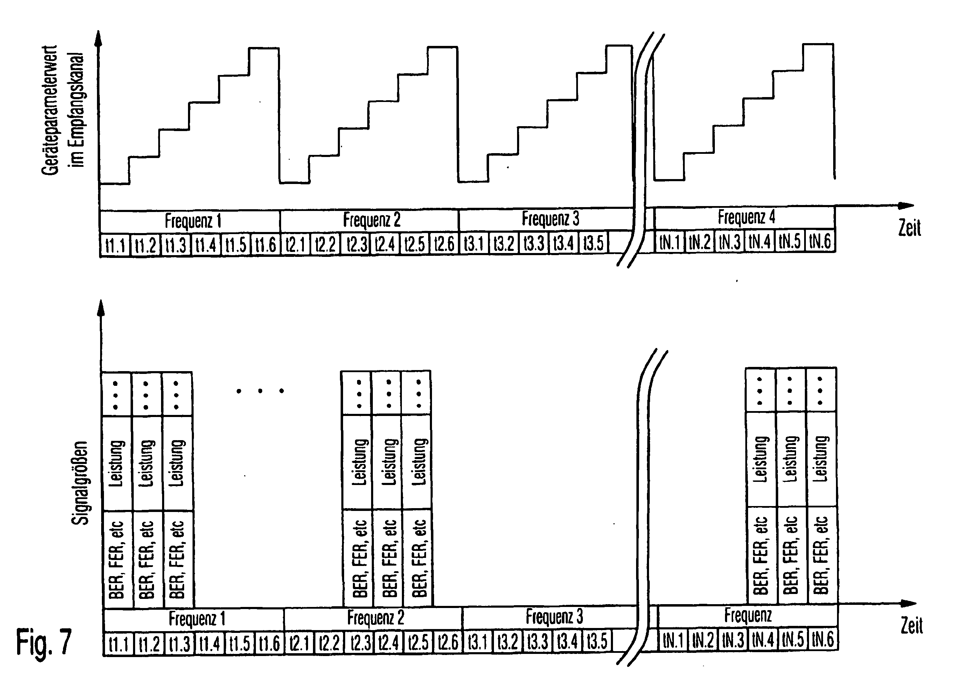

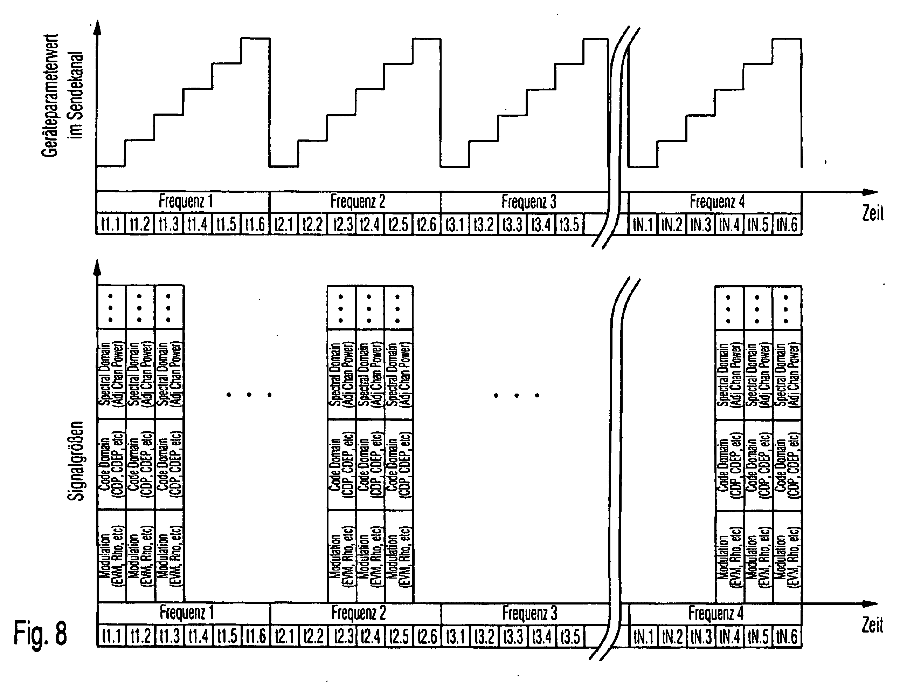

In Fig. 7 sind Beispiele von zu messenden Signalgrößen des Empfangssignals bei Variation eines Geräteparameterwertes eines im Empfangskanal des Mobilfunkgerätes 3₁ einstellbaren Geräteparameters und bei Variation des Frequenzwertes über der Zeit dargestellt. Analog sind in Fig. 8 Beispiele von zu messenden Signalgrößen des Sendesignals bei Variation eines Geräteparameterwertes eines im Sendekanal des Mobilfunkgerätes 3₁ einstellbaren Geräteparameters und bei Variation des Frequenzwertes über der Zeit dargestellt.

Das Durchstimmen der einzelnen Geräteparameterwerte eines durchzustimmenden Geräteparameters kann entweder inkremental - wie beispielsweise in den Figuren 7 und 8 dargestellt - oder dekremental - wie beispielsweise in den Figuren 9, 10 und 11 dargestellt - erfolgen.

In einer dritten Ausführungsform des erfindungsgemäßen Systems zur Ermittlung der Abhängigkeit zwischen Geräteparametern eines Mobilfunkgeräts und Signalgrößen eines vom Mobilfunkgerät gesendeten und/oder empfangenen Signals in Fig. 13 erfolgt in Abgrenzung zur ersten und zweiten Ausführungsform des erfindungsgemäßen Systems die Übertragung zwischen dem Mobilfunkgerät 3₁ und dem Messgerät 5 in beiden Richtungen des Sende- und Empfangsbetriebs des Mobilfunkgeräts 3 über eine einzige Schnittstelle 7' und eine einzige Verbindung 6'. Folglich kann die dritte Ausführungsform des erfindungsgemäßen Systems für die simultane Erfassung der einzelnen Signalgrößen des Sende- und Empfangssignals in der zweiten Ausführungsform des erfindungsgemäßen Verfahrens nicht eingesetzt werden.

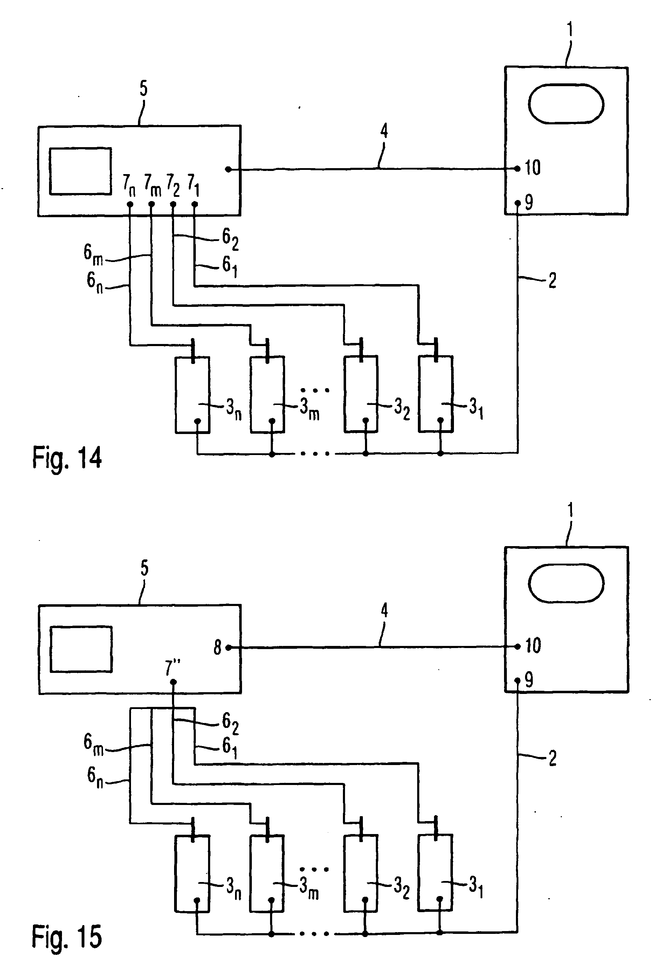

In Fig. 14 ist das Blockschaltbild eines erfindungsgemäßen Systems zur parallelen Ermittlung der Abhängigkeit zwischen Geräteparametern in mehreren Mobilfunkgeräten 3₁,3₂,..,3ₘ,3ₙ und Signalgrößen eines von jeweils mehreren Mobilfunkgeräten 3₁,3₂,..,3ₘ,3ₙ gesendeten und/oder empfangenen Signals dargestellt. Da das Messgerät 5 insgesamt n Mess-Einheiten und n Schnittstellen 7₁,7₂,..,7ₘ,7ₙ aufweist, die über jeweils eine Verbindungsleitung 6₁,6₂,..,6ₘ,6ₙ jeweils mit einem der insgesamt n Mobilfunkgeräte 3₁,3₂,..,3ₘ,3ₙ verbunden sind, ist eine parallele Ermittlung der Abhängigkeit zwischen Geräteparametern in mehreren Mobilfunkgeräten 3₁,3₂,..,3ₘ,3ₙ und Signalgrößen eines von jeweils mehreren Mobilfunkgeräten 3₁,3₂,..,3ₘ,3ₙ gesendeten und/oder empfangenen Signals möglich.

Den einzelnen Mess-Einheiten des Messgerätes 5 und den einzelnen Mobilfunkgeräten 3₁,3₂,..,3ₘ,3ₙ werden von der Einheit zur übergeordneten Ablaufsteuerung 1 über jeweils die Verbindungsleitungen 4 und 2 die Signalpegel und die einzelnen Frequenzen des Sende- und Empfangssignals und die im jeweiligen Mobilfunkgerät 3₁,3₂,..,3ₘ,3ₙ einzustellenden Geräteparameterwerte der einzelnen Geräteparameter im Sinne der Verfahrensschritte S10, S100, S200, S300 und S400 der einzelnen Ausführungsformen und deren Unterausführungsvarianten des erfindungsgemäßen Verfahrens in den Figuren 2, 3, 4, 5 und 6 übertragen.

Nach der Triggerung und Synchronisierung des Messgerätes 5 mit den einzelnen Mobilfunkgeräten 3₁,3₂,..,3ₘ,3ₙ in den Verfahrensschritten S20, S110, S210, S310 und S410 und der Einstellung des Signalpegels und des ersten Frequenzwertes des Sende- und Empfangssignals in den einzelnen Mobilfunkgeräten 3₁,3₂,..,3ₘ,3ₙ und im Messgerät 5 sowie des ersten Geräteparameterwerts des ersten im Sende- bzw. Empfangskanal des jeweiligen Mobilfunkgerätes 3₁,3₂,..,3ₘ,3ₙ einzustellenden Geräteparameters in den Verfahrensschritten S30, S120, S220, S320, S420 und S430 in den Figuren 2, 3, 4, 5 und 6 werden die einzelnen Signalgrößen des Sende- und Empfangssignals der einzelnen Mobilfunkgeräte 3₁,3₂,..,3ₘ3ₙ, für jeden einzelnen Frequenzwert und jeden einzelnen Geräteparameterwert jedes einzustellenden Geräteparameters in den einzelnen Verfahrensschritten S40 bis S70, S130 bis S160, S230 bis S250, S330 bis S380 und S440 bis S480 der einzelnen Ausführungsformen und deren Unterausführungsvarianten des erfindungsgemäßen Verfahrens in den Figuren 2, 3, 4, 5 und 6 gemessen.

In Fig. 15 ist schließlich das Blockschaltbild einer zweiten Ausführungsform des erfindungsgemäßen Systems zur parallelen Ermittlung der Abhängigkeit zwischen Geräteparametern in mehreren Mobilfunkgeräten 3₁,3₂,..,3ₘ3ₙ und Signalgrößen eines von jeweils mehreren Mobilfunkgeräten 3₁,3₂,..,3ₘ,3ₙ empfangenen Signals dargestellt, das in Abgrenzung zur ersten Ausführungsform nur eine einzige Schnittstelle 7" aufweist, an die alle Verbindungsleitungen 6₁,6₂,..,6ₘ,6ₙ geführt sind. Gegenüber der Ausführungsform des erfindungsgemäßen Systems zur parallelen Ermittlung der Abhängigkeit zwischen Geräteparametern in mehreren Mobilfunkgeräten 3₁,3₂,..,3ₘ,3ₙ und Signalgrößen eines von jeweils mehreren Mobilfunkgeräten 3₁,3₂,..,3ₘ,3ₙ gesendeten und/oder empfangenen Signals in Fig. 14 mit insgesamt n Messe-Einheiten weist das Messgerät 5 in der zweiten Ausführungsform in Fig. 15 nur eine einzige MessEinheit auf.

Da alle Mobilfunkgeräte 3₁,3₂,..,3ₘ,3ₙ zur Ermittelung der einzelnen Signalgrößen des Empfangssignals in Abhängigkeit der jeweils eingestellten Geräteparameterwerte des jeweiligen Geräteparameters mit einem dem Empfangssignal entsprechenden, identischen Testsignal empfangsseitig beaufschlagt werden, wird dieses Testsignal einmalig vom Messgerät 5 generiert, über die einheitliche Schnittstelle 7" gemäß Fig. 15 vom Messgerät 5 ausgegeben und über die einzelnen Verbindungsleitungen 6₁,6₂,..,6ₘ,6ₙ den einzelnen Mobilfunkgeräten 3₁,3₂,..,3ₘ,3ₙ zugeführt.

Die Erfindung ist nicht auf die dargestellten Ausführungeformen beschränkt. Die Erfindung ist insbesondere nicht auf einen bestimmten Mobilfunkstandard beschränkt. Von der Erfindung sind auch Mobilfunkgeräte mit mehreren Sende- und Empfangsantennen (so genannte MIMO-Systeme) und damit mehreren Sende- und Empfangskanälen abgedeckt.

## Patentansprüche

1. Verfahren zur Ermittlung der Abhängigkeit zwischen mehreren Geräteparameterwerten von jeweils mindestens einem Geräteparameter eines Mobilfunkgeräts (3₁,3₂,...,3ₘ,3ₙ) und mindestens einer Signalgröße eines vom Mobilfunkgerät (3₁,3₂,...,3ₘ,3ₙ) gesendeten und/oder empfangenen Signals, indem in mindestens einem Mobilfunkgerät (3₁,3₂,...,3ₘ,3ₙ) für eine bestimmte Anzahl von Frequenzen des jeweils gesendeten und/oder empfangenen Signals jeweils mehrere Geräteparameterwerte von mindestens einem Geräteparameter des jeweiligen Mobilfunkgeräts (3₁,3₂,...,3ₘ,3ₙ) eingestellt und die zugehörigen Signalgrößen eines vom jeweiligen Mobilfunkgerät (3₁,3₂,...,3ₘ,3ₙ) gesendeten und/oder empfangenen Signals gemessen werden,
**dadurch gekennzeichnet,**
**dass** zu Beginn der Messungen alle Frequenzen und die zu jeder Frequenz jeweils gehörigen Geräteparameterwerte von jeweils mindestens einem Geräteparameter im jeweiligen Mobilfunkgerät (3₁,3₂,..,3ₘ,3ₙ) vorliegen.

2. Verfahren nach Anspruch 1,
**dadurch gekennzeichnet,**
**dass** die Messungen aller zu jeweils einer Frequenz und jeweils einem Geräteparameterwert eines Geräteparameters gehörigen Signalgrößenwerte des vom jeweiligen Mobilfunkgerät (3₁,3₂,...,3ₘ,3ₙ) gesendeten und empfangenen Signals jeweils unmittelbar aufeinander folgen.

3. Verfahren nach Anspruch 2,
**dadurch gekennzeichnet,**
**dass** die Messungen aller zu jeweils einer identischen Frequenz und zu jeweils einem unterschiedlichen Geräteparameterwert eines Geräteparameters gehörigen Signalgrößenwerte des vom jeweiligen Mobilfunkgerät (3₁,3₂,...,3ₘ,3ₙ) gesendeten oder/und empfangenen Signals jeweils unmittelbar aufeinander folgen.

4. Verfahren nach Anspruch 3,
**dadurch gekennzeichnet,**
**dass** die Messungen aller zu jeweils einer identischen Frequenz und zu jeweils einem unterschiedlichen Geräteparameterwert eines Geräteparameters gehörigen Signalgrößenwerte des vom jeweiligen Mobilfunkgerät (3₁,3₂,...,3ₘ,3ₙ) gesendeten Signals vor oder nach den Messungen aller zu jeweils einer identischen Frequenz und zu jeweils einem unterschiedlichen Geräteparameterwert eines Geräteparameters gehörigen Signalgrößenwerte des vom jeweiligen Mobilfunkgerät (3₁,3₂,...,3ₘ,3ₙ) empfangenen Signals erfolgen.

5. Verfahren nach Anspruch 3,
**dadurch gekennzeichnet,**
**dass** für jede vorgegebene und zueinander gehörige Frequenz des gesendeten und empfangenen Signals und jeden Geräteparameterwert jedes Geräteparameters die Messung des zugehörigen Signalgrößenwertes des gesendeten Signals simultan zur Messung des zugehörigen Signalgrößenwertes des empfangenen Signals erfolgt.

6. Verfahren nach Anspruch 3,
**dadurch gekennzeichnet,**
**dass** für jede vorgegebene und zueinander gehörige Frequenz des gesendeten und empfangenen Signals und jeden Geräteparameterwert jedes Geräteparameters die Messung des zugehörigen Signalgrößenwertes des gesendeten Signals unmittelbar vor oder nach der Messung des zugehörigen Signalgrößenwertes des empfangenen Signals erfolgt.

7. Verfahren nach einem der Ansprüche 3 bis 6,
**dadurch gekennzeichnet,**
**dass** für die Messung aller zu jeweils einer identischen Frequenz gehörigen Signalgrößenwerte des vom jeweiligen Mobilfunkgerät (3₁,3₂,...,3ₘ,3ₙ) gesendeten und/oder empfangenen Signals die Geräteparameterwerte der einzelnen Geräteparameter jeweils inkrementiert oder dekrementiert werden.

8. Verfahren nach einem der Ansprüche 1 bis 7,
**dadurch gekennzeichnet,**
**dass** alle zu jedem Geräteparameterwert jedes Geräteparameters und jeweils einer Frequenz des gesendeten und/oder empfangenen Signals gehörigen Messungen der Signalgrößen des gesendeten und/oder empfangenen Signals vor allen zu jedem Geräteparameterwert jedes Geräteparameters und jeweils einer weiteren Frequenz des gesendeten und/oder empfangenen Signals gehörigen Messungen der Signalgrößen des gesendeten und/oder empfangenen Signals durchgeführt werden.

9. Verfahren nach einem der Ansprüche 1 bis 7,
**dadurch gekennzeichnet,**
**dass** alle zu jedem Geräteparameterwert eines Geräteparameters und zu jeder vorgegebenen Frequenz des gesendeten und/oder empfangenen Signals gehörigen Messungen der Signalgrößen des gesendeten und/oder empfangenen Signals vor allen zu jedem Geräteparameterwert eines weiteren Geräteparameters und zu jeder vorgegebenen Frequenz des gesendeten und/oder empfangenen Signals gehörigen Messungen der Signalgrößen des gesendeten und/oder empfangenen Signals durchgeführt werden.

10. Verfahren nach einem der Ansprüche 1 bis 9,
**dadurch gekennzeichnet,**
**dass** für jede Messung eines vom jeweiligen Mobilfunkgerät (3₁,3₂,...,3ₘ,3ₙ) generierten Signalgrößenwertes des gesendeten und/oder empfangenen Signals jeweils ein Zeitschlitz, Slot, mit einer bestimmten Zeitdauer vorgesehen ist.

11. Verfahren nach Anspruch 10,
**dadurch gekennzeichnet,**
**dass** die Zeitschlitze der zu einer vorgegebenen Frequenz des gesendeten und/oder empfangenen Signals jeweils gehörigen Messungen der Signalgrößenwerte in einem Zeitrahmen unmittelbar aneinandergrenzen.

12. Verfahren nach Anspruch 10,
**dadurch gekennzeichnet,**
**dass** die Zeitschlitze der zu einer vorgegebenen Frequenz des gesendeten und/oder empfangenen Signals jeweils gehörigen Messungen der Signalgrößenwerte jeweils durch eine bestimmte Anzahl von Zeitschlitzen, in denen keine Messung durchgeführt wird, voneinander zeitlich getrennt in einem Zeitrahmen angeordnet sind.

13. Verfahren nach einem der Ansprüche 10 bis 12,
**dadurch gekennzeichnet,**
**dass** im Übergang zwischen zwei vorgegebenen Frequenzen des gesendeten und/oder empfangenen Signals jeweils ein Zeitschlitz eingefügt ist, in dem keine Messung erfolgt.

14. Verfahren nach einem der Ansprüche 1 bis 13,
**dadurch gekennzeichnet,**
**dass** bei im jeweiligen Mobilfunkgerät (3₁,3₂,...,3ₘ,3ₙ) bereits abgespeicherten Frequenzen und zu den Frequenzen jeweils gehörigen Geräteparameterwerten der einzelnen Geräteparameter die Messung der zu den einzelnen Geräteparameterwerten der einzelnen Geräteparameter gehörigen Signalgrößenwerte der einzelnen Signalgrößen durch eine Triggerung des jeweiligen Mobilfunkgeräts (3₁,3₂,...,3ₘ,3ₙ) von extern gestartet wird.

15. Verfahren nach einem der Ansprüche 1 bis 13,
**dadurch gekennzeichnet,**
**dass** die Messung der zu den einzelnen Geräteparameterwerten der einzelnen Geräteparameter gehörigen Signalgrößenwerte der einzelnen Signalgrößen nach Abspeicherung der Frequenzen und der zu den Frequenzen jeweils gehörigen Geräteparameterwerten der einzelnen Geräteparameter im jeweiligen Mobilfunkgerät (3₁,3₂,...,3ₘ,3ₙ) gestartet wird.

16. Verfahren nach einem der Ansprüche 1 bis 15,
**dadurch gekennzeichnet,**
**dass** vor der Durchführung der einzelnen Messungen das jeweilige Mobilfunkgerät (3₁,3₂,..,3ₘ,3ₙ) mit einem Messgerät (5) und/oder einer Einheit zur übergeordneten Ablaufsteuerung (1) synchronisiert wird.

17. System zur Ermittlung der Abhängigkeit zwischen mehreren Geräteparameterwerten von jeweils mindestens einem Geräteparameter in mindestens einem Mobilfunkgerät (3₁,3₂,...,3ₘ,3ₙ) und mindestens einer Signalgröße eines vom jeweiligen Mobilfunkgeräts (3₁,3₂,...,3ₘ,3ₙ) gesendeten und/oder empfangenen Signals mit einem Messgerät (5) und mindestens einem Mobilfunkgerät (3₁,3₂,...,3ₘ,3ₙ), das für eine bestimmte Anzahl von vorgegebenen Frequenzen und für eine bestimmte Anzahl von im jeweiligen Mobilfunkgerät (3₁,3₂,...,3ₘ,3ₙ) eingestellten Geräteparameterwerten von Geräteparametern jeweils ein gesendetes und/oder empfangenes Signal erzeugt,
**dadurch gekennzeichnet,**
**dass** zu Beginn der Messungen alle Frequenzen und die zu jeder Frequenz jeweils gehörigen Geräteparameterwerte von jeweils mindestens einem Geräteparameter in jedem Mobilfunkgerät (3₁,3₂,...,3ₘ,3ₙ) vorliegen.

18. System nach Anspruch 17,
**dadurch gekennzeichnet**,
das von einer Einheit zur übergeordneten Ablaufsteuerung (1) alle Frequenzen des gesendeten Signals und alle Geräteparameterwerte jedes Geräteparameters jedem Mobilfunkgerät (3₁,3₂,...,3ₘ,3ₙ) und alle Frequenzen des empfangenen Signals dem Messgerät (5) zu Beginn der Messungen zugeführt werden.

19. System nach Anspruch 17 oder 18,
**dadurch gekennzeichnet,**
**dass** die Übertragung des von mindestens einem Mobilfunkgerät (3₁3₂,...,3ₘ,3ₙ) zum Messgerät (5) jeweils gesendeten und empfangenen Signals über jeweils eine Leitungsverbindung (6;6';6₁,6₂,..,6ₘ,6ₙ) erfolgt.

20. System nach Anspruch 17 oder 18,
**dadurch gekennzeichnet,**
**dass** die Übertragung des von einem Mobilfunkgerät (3) zum Messgerät (5) gesendeten und empfangenen Signals über zwei Leitungsverbindungen (2';6) erfolgt.

## Claims

1. Method for determining the respective dependence between several device-parameter values of at least one device parameter of a mobile telephone (3₁, 3₂, ..., 3ₘ, 3ₙ) and at least one signal parameter of a signal transmitted and/or received by the mobile telephone (3₁, 3₂, ..., 3ₘ, 3ₙ) by setting, respectively in at least one mobile telephone (3₁, 3₂, ..., 3ₘ, 3ₙ), several device-parameter values of at least one device parameter of the respective mobile telephone (3₁, 3₂, ..., 3ₘ, 3ₙ) for a given number of frequencies of the transmitted and/or received signal and by measuring the associated signal parameters of a signal transmitted and/or received by the respective mobile telephone (3₁, 3₂, ..., 3ₘ, 3ₙ),
**characterised in that**
all of the frequencies and the respective device-parameter values of at least one device parameter associated with each frequency are present in the respective mobile telephone (3₁, 3₂, ..., 3ₘ, 3ₙ) at the start of the measurements.

2. Method according to claim 1,
**characterised in that,**
in each case, the measurements of all of the signal-parameter values of the signal transmitted and received by the respective mobile telephone (3₁, 3₂, ..., 3ₘ, 3ₙ), which are associated respectively with one frequency and one device-parameter value of a device parameter, follow one another in direct succession.

3. Method according to claim 2,
**characterised in that**,
in each case, the measurements of all the signal-parameter values of the signal transmitted and/or received by the respective mobile telephone (3₁, 3₂, ..., 3ₘ, 3ₙ), which are associated respectively with an identical frequency and a different device-parameter value of the device parameter, follow one another in direct succession.

4. Method according to claim 3,
**characterised in that**,
in each case, the measurements of all signal-parameter values of the signal transmitted by the respective mobile telephone (3₁, 3₂, ..., 3ₘ, 3ₙ), which are associated respectively with an identical frequency and a different device-parameter value of a device parameter, are implemented before or after the measurements of all of the signal-parameter values of the signal received by the respective mobile telephone (3₁, 3₂, ..., 3ₘ, 3ₙ), which are associated respectively with an identical frequency and a different device-parameter value of a device parameter.

5. Method according to claim 3,
**characterised in that**,
for every specified and mutually-associated frequency of the transmitted and received signal and every device-parameter value of every device parameter, the measurement of the associated signal-parameter value of the transmitted signal is implemented simultaneously with the measurement of the associated signal-parameter value of the received signal.

6. Method according to claim 3,
**characterised in that**,
for every specified and mutually-associated frequency of the transmitted and received signal and every device-parameter value of every device parameter, the measurement of the associated signal-parameter value of the transmitted signal is implemented directly before or after the measurement of the associated signal-parameter value of the received signal.

7. Method according to any one of claims 3 to 6,
**characterised in that**,
for the measurement of all of the signal-parameter values of the signal transmitted and/or received by the respective mobile telephone (3₁, 3₂, ..., 3ₘ, 3ₙ), which are associated respectively with an identical frequency, the device-parameter values of the individual device parameters are incremented or decremented respectively.

8. Method according to any one of claims 1 to 7,
**characterised in that**
all of the measurements of the signal parameters of the transmitted and/or received signal, which are associated respectively with every device-parameter value of every device parameter and respectively with one frequency of the transmitted and/or received signal, are implemented before all of the measurements of the signal parameters of the transmitted and/or received signal, which are associated respectively with every device-parameter value of every device parameter and respectively with one further frequency of the transmitted and/or received signal.

9. Method according to any one of claims 1 to 7,
**characterised in that**
all of the measurements of the signal parameters of the transmitted and/or received signal, which are associated respectively with every device-parameter value of a device parameter and with every specified frequency of the transmitted and/or received signal, are implemented before all of the measurements of the signal parameters of the transmitted and/or received signal, which are associated respectively with every device-parameter value of a further device parameter and with every specified frequency of the transmitted and/or received signal.

10. Method according to any one of claims 1 to 9,
**characterised in that**
a timeslot, slot, with a given duration is provided for every measurement of a signal-parameter value of the signal transmitted and/or received, which is generated by the respective mobile telephone (3₁, 3₂, ..., 3ₘ, 3ₙ).

11. Method according to claim 10,
**characterised in that**
the timeslots for the measurements of the signal-parameter values associated respectively with a
specified frequency of the transmitted and/or received signal are directly adjacent to one another within a timeframe.

12. Method according to claim 10,
**characterised in that**
the timeslots for the measurements of the signal-parameter values associated respectively with a specified frequency of the transmitted and/or received signal are arranged within a timeframe separated from one another in time in each case by a given number of time slots, in which no measurement is implemented.

13. Method according to any one of claims 10 to 12,
**characterised in that**,
in each case, a time slot, in which no measurement is implemented, is inserted in the transition between two specified frequencies of the transmitted and/or received signal.

14. Method according to any one of claims 1 to 13,
**characterised in that**,
in the case of frequencies already stored in the respective mobile telephone (3₁, 3₂, ..., 3ₘ, 3ₙ) and device-parameter values of the individual device parameters associated with the respective frequencies, the measurement of the signal-parameter values of the individual signal parameters, which are associated with the individual device-parameter values of the individual device parameters, is initiated externally by a triggering of the respective mobile telephone (3₁, 3₂, ..., 3ₘ, 3ₙ) .

15. Method according to any one of claims 1 to 13,
**characterised in that**
the measurement of the signal-parameter values of the individual signal parameters associated with the individual device-parameter values of the individual device parameters is initiated after the storage in the respective mobile telephone (3₁, 3₂, ..., 3ₘ, 3ₙ) of the frequencies and the device-parameter values of the individual device parameters associated respectively with the frequencies.

16. Method according to any one of claims 1 to 15,
**characterised in that**,
before the implementation of the individual measurements, the respective mobile telephone (3₁, 3₂, ..., 3ₘ, 3ₙ) is synchronised with a measuring instrument (5) and/or a superordinate procedural-control unit (1).

17. System for determining the dependence between several device-parameter values in each case of at least one device parameter in at least one mobile telephone (3₁, 3₂, ..., 3ₘ, 3ₙ) and at least one signal parameter of a signal transmitted and/or received by the respective mobile telephone (3₁, 3₂, ..., 3ₘ, 3ₙ) with a measuring instrument (5) and at least one mobile telephone (3₁, 3₂, ..., 3ₘ, 3ₙ), which generates a transmitted and/or received signal respectively for a given number of specified frequencies and for a given number of device-parameter values of device parameters set in the respective mobile telephone (3₁, 3₂, ..., 3ₘ, 3ₙ),
**characterised in that**,
all of the frequencies and the device-parameter values of at least one device parameter respectively associated with each frequency are present in every mobile telephone (3₁, 3₂, ..., 3ₘ, 3ₙ) at the start of the measurements.

18. System according to claim 17,
**characterised in that**,
at the start of the measurements, all of the frequencies of the transmitted signal and all of the device-parameter values of every device parameter are supplied to every mobile telephone (3₁, 3₂, ..., 3ₘ, 3ₙ), and all of the frequencies of the received signal are supplied to the measuring instrument (5) from a superordinate procedural-control unit (1).

19. System according to claim 17 or 18,
**characterised in that**
the transmission of the signal transmitted to the measuring instrument (5) from at least one mobile telephone (3₁, 3₂, ..., 3ₘ, 3ₙ) and received respectively is implemented in each case via a line connection (6; 6'; 6₁, 6₂, ..., 6ₘ, 6ₙ).

20. System according to claim 17 or 18,
**characterised in that**
the transmission to the measuring instrument (5) of the signal transmitted from a mobile telephone (3) and received is implemented via two line connections (2' ; 6).

## Revendications

1. Procédé pour déterminer la dépendance entre plusieurs valeurs de paramètres d'appareil d'au moins un paramètre d'appareil respectif d'un téléphone mobile (3₁, 3₂,..., 3ₘ, 3ₙ) et d'au moins une grandeur de signal d'un signal envoyé et/ou reçu par le téléphone mobile (3₁, 3₂, ..., 3ₘ, 3ₙ), dans lequel, dans au moins un téléphone mobile (3₁, 3₂, ..., 3ₘ, 3ₙ), pour un nombre déterminé de fréquences du signal envoyé et/ou reçu respectif, plusieurs valeurs de paramètres d'appareil respectives d'au moins un paramètre d'appareil du téléphone mobile respectif (3₁, 3₂, ..., 3ₘ, 3ₙ) sont réglées et les grandeurs de signal associées d'un signal envoyé et/ou reçu par le téléphone mobile respectif (3₁, 3₂, ..., 3ₘ, 3ₙ) sont mesurées,
**caractérisé en ce que**
au début des mesures, toutes les fréquences et les valeurs de paramètres d'appareil respectives associées à chaque fréquence d'au moins un paramètre d'appareil respectif existent dans le téléphone mobile respectif (3₁, 3₂, ..., 3ₘ, 3ₙ).

2. Procédé selon la revendication 1,
**caractérisé en ce que**
les mesures de toutes les valeurs de grandeur de signal associées à une fréquence respective et à une valeur de paramètre d'appareil respective d'un paramètre d'appareil du signal envoyé et reçu par le téléphone mobile respectif (3₁, 3₂, ..., 3ₘ, 3ₙ) se suivent immédiatement respectivement.

3. Procédé selon la revendication 2,
**caractérisé en ce que**
les mesures de toutes les valeurs de grandeur de signal associées à une fréquence identique respective et à une valeur de paramètre d'appareil différente respective du signal envoyé et/ou reçu par le téléphone mobile respectif (3₁, 3₂, ..., 3ₘ, 3ₙ) se suivent immédiatement respectivement.

4. Procédé selon la revendication 3,
**caractérisé en ce que**
les mesures de toutes les valeurs de grandeur de signal associées à une fréquence identique respective et à une valeur de paramètres d'appareil différente respective d'un paramètre d'appareil du signal envoyé par le téléphone mobile respectif (3₁, 3₂, ..., 3ₘ, 3ₙ) se produisent avant ou après les mesures de toutes les valeurs de grandeur de signal associées à une fréquence identique respective et à une valeur de paramètre d'appareil différente respective d'un paramètre d'appareil du signal reçu par le téléphone mobile respectif (3₁, 3₂, ..., 3ₘ, 3ₙ) .

5. Procédé selon la revendication 3,
**caractérisé en ce que**
pour chaque fréquence prédéterminée et associée du signal envoyé et reçu pour chaque valeur de paramètre d'appareil de chaque paramètre d'appareil, la mesure de la valeur de grandeur de signal associée du signal envoyé se produit simultanément à la mesure de la valeur de grandeur de signal associée du signal reçu.

6. Procédé selon la revendication 3,
**caractérisé en ce que**
pour chaque fréquence prédéterminée et associée du signal envoyé et reçu et pour chaque valeur de paramètre d'appareil de chaque paramètre d'appareil, la mesure de la valeur de grandeur de signal associée du signal envoyé se produit immédiatement avant ou après la mesure de la valeur de grandeur de signal associée du signal envoyé.

7. Procédé selon l'une des revendications 3 à 6,
**caractérisé en ce que**
pour la mesure de toutes les valeurs de grandeur de signal associées à une fréquence identique respective du signal envoyé et/ou reçu par le téléphone mobile respectif (3₁, 3₂, ..., 3ₘ, 3ₙ), les valeurs de paramètres d'appareil des différents paramètres d'appareil sont respectivement incrémentés ou décrémentés.

8. Procédé selon l'une des revendications 1 à 7,
**caractérisé en ce que**
toutes les mesures des grandeurs de signal du signal envoyé et/ou reçu associées à chaque valeur de paramètres d'appareil de chaque paramètre d'appareil et à une fréquence respective du signal envoyé et/ou reçu sont effectuées avant toutes les mesures des grandeurs de signal du signal envoyé et/ou reçu associées à chaque valeur de paramètre d'appareil de chaque paramètre d'appareil et à une autre fréquence respective du signal envoyé et/ou reçu.

9. Procédé selon l'une des revendications 1 à 7,
**caractérisé en ce que** toutes les mesures des grandeurs de signal du signal envoyé et/ou reçu associées à chaque valeur de paramètre d'appareil d'un paramètre d'appareil et à chaque fréquence prédéterminée du signal envoyé et/ou reçu sont effectuées avant toutes les mesures des grandeurs de signal du signal envoyé et/ou reçu associées à un autre paramètre d'appareil et à chaque fréquence prédéterminée du signal envoyé et/ou reçu.

10. Procédé selon l'une des revendications 1 à 9,
**caractérisé en ce que**
pour chaque mesure d'une valeur de grandeur de signal du signal envoyé et/ou reçu générée par le téléphone mobile respectif (3₁, 3₂, ..., 3ₘ, 3ₙ), un intervalle temporel respectif, slot, avec une période prédéterminée est prévu.

11. Procédé selon la revendication 10,
**caractérisé en ce que**
les intervalles temporels des mesures respectives des valeurs de grandeur de signal associées à une fréquence prédéterminée du signal envoyé et/ou reçu sont immédiatement contigus dans un cadre temporel.

12. Procédé selon la revendication 10,
**caractérisé en ce que**
les intervalles temporels des mesures respectives des valeurs de grandeur de signal associées à une fréquence prédéterminée du signal reçu et/ou envoyé sont disposés dans un cadre temporel séparés les uns des autres temporellement respectivement par un nombre prédéterminé d'intervalles temporels, dans lesquels aucune mesure n'est effectuée.

13. Procédé selon l'une des revendications 10 à 12,
**caractérisé en ce que**
lors du passage entre deux fréquences prédéterminées du signal reçu et/ou envoyé, un intervalle temporel respectif est inséré, dans lequel aucune mesure ne se produit.

14. Procédé selon l'une des revendications 1 à 13,
**caractérisé en ce que**
dans le cas de fréquences déjà mémorisées dans le téléphone mobile respectif (3₁, 3₂, ..., 3ₘ, 3ₙ) et de valeurs de paramètre d'appareil du paramètre différent associées respectivement aux fréquences, la mesure de la valeur de grandeur de signal des grandeurs de signal différentes associées aux valeurs de paramètre d'appareil différentes des paramètres d'appareil différents est débutée depuis l'extérieur par un déclenchement du téléphone mobile respectif (3₁, 3₂, ..., 3ₘ, 3ₙ) .

15. Procédé selon l'une des revendications 1 à 13,
**caractérisé en ce que**
la mesure des valeurs de grandeur de signal des grandeurs de signal différentes associées aux valeurs de paramètre d'appareil différente des paramètres d'appareil différents est débutée après la mémorisation des fréquences et des valeurs de paramètre d'appareil des paramètres d'appareil différents associées respectivement aux fréquences dans le téléphone mobile respectif (3₁, 3₂, ..., 3ₘ, 3ₙ).

16. Procédé selon l'une des revendications 1 à 15,
**caractérisé en ce que**
avant l'exécution des différentes mesures, le téléphone mobile respectif (3₁, 3₂, ..., 3ₘ, 3ₙ) est synchronisé grâce à un appareil de mesure (5) et/ou grâce à une unité de commande de fonctionnement principale (1).

17. Système pour déterminer la dépendance entre plusieurs valeurs de paramètre d'appareil d'au moins un paramètre d'appareil respectif dans au moins un téléphone mobile (3₁, 3₂, ..., 3ₘ, 3ₙ) et d'au moins une grandeur de signal d'un signal envoyé et/ou reçu par le téléphone mobile respectif (3₁, 3₂, ..., 3ₘ, 3ₙ) grâce à un appareil de mesure (5) et au moins un téléphone mobile (3₁, 3₂, ..., 3ₘ, 3ₙ), qui génère un signal envoyé et/ou reçu respectif pour un nombre déterminé de fréquences prédéterminées et pour un nombre déterminé de valeurs de paramètre d'appareil de paramètres d'appareil réglées dans le téléphone mobile respectif (3₁, 3₂, ..., 3ₘ, 3ₙ).
**caractérisé en ce que**
au début des mesures, toutes les fréquences et les valeurs de paramètre d'appareil d'au moins un paramètre d'appareil respectif associé respectivement à chaque fréquence existent dans chaque téléphone mobile (3₁, 3₂, ..., 3ₘ, 3ₙ).

18. Système selon la revendication 17,
**caractérisé en ce que**
toutes les fréquences du signal envoyé et toutes les valeurs de paramètre d'appareil de chaque paramètre d'appareil sont délivrées à chaque téléphone mobile (3₁, 3₂, ..., 3ₘ, 3ₙ) et toutes les fréquences du signal reçu sont délivrées à l'appareil de mesure (5) au début des mesures par une unité en vue de la commande de fonctionnement principale.

19. Système selon la revendication 17 ou 18,
**caractérisé en ce que** la transmission du signal respectif envoyé et reçu par au moins un téléphone mobile (3₁, 3₂, ..., 3ₘ, 3ₙ) à l'appareil de mesure (5) est effectuée par l'intermédiaire d'une liaison par câble (6 ; 6' ; 6₁, 6₂, ..., 6ₘ, 6ₙ).

20. Système selon la revendication 17 ou 18,
**caractérisé en ce que** la transmission du signal envoyé et reçu par un téléphone mobile (3) à l'appareil de mesure (5) est effectuée par l'intermédiaire de deux liaisons par câble (2' ; 6).
